# EUROPEAN PATENT APPLICATION

(11) **EP 4 462 488 A1**
(43) Date of publication of application: **13.11.2024**
(21) Application number: 23172467.5
(22) Date of filing: 09.05.2023
(51) Int. Cl.: H01L 31/05, H02S 20/22, H02S 30/20, H02S 40/36

(54) **PRE-ASSEMBLED SOLAR SHEET FOR MOUNTING ON A SUPPORTING STRUCTURE**

(71) Applicant: Sono Motors GmbH, 80935 München (DE)
(72) Inventor: PALM, Jörg, 80935 Munich (DE); SCHICHO, Sandra, 80935 Munich (DE)
(74) Representative: Gebauer, Dieter Edmund

(57) **Abstract**

A solar sheet (1) for mounting on a supporting structure (9), comprising:
- a carrier sheet (2) having a first side (A) and a second side (B) opposite to said first side,
- at least one solar sheet unit (100), comprising:
i) multiple solar modules (3), attached to said carrier sheet (2) on said first side (A), each one of said solar modules (3) having electric connectors (15) for both electric polarities for providing electric power generated by said solar module (3),
ii) multiple electric conductors (4), attached to said first side (A) of said carrier sheet (2) and/or to said second side (B) of said carrier sheet (2), said electric connectors (15) of said solar modules (3) being electrically connected to said electric conductors (4) such that said solar modules (3) are interconnected in series and/or in parallel, with one end portion (5) of each one of said electric conductors (4) leading to either another solar module (3) or into a common connection zone (6) of said solar sheet unit (100).

## Description

### FIELD OF THE INVENTION

The present invention is in the technical field of photovoltaic power generation and relates to a pre-assembled solar sheet comprising at least one solar sheet unit having multiple solar modules for mounting on a supporting structure such as a supporting layer which forms part of the outer skin of a vehicle or building. Furthermore, the invention relates to a solar sheet arrangement comprising a supporting structure and at least one solar sheet unit of such pre-assembled solar sheet. Moreover, the invention relates to a method for producing such pre-assembled solar sheet and a method for producing such solar sheet arrangement.

### TECHNICAL BACKGROUND

Solar modules with multiple interconnected solar cells for the photovoltaic (PV) generation of electric power from sunlight are well known to those skilled in the art. Conventionally, solar cells are divided into thick-film and thin-film solar cells according to the layer thickness. In the case of thin-film solar cells, the interconnection of solar cells can be integrated into the solar cell production process, whereas in the case of thick-film solar cells, the interconnection is achieved by means of electric interconnectors. Currently, silicon (Si) is the most commonly used semiconducting material, with monocrystalline and polycrystalline silicon used for thick film cells and amorphous silicon for thin film cells. Silicon is available in large quantities and the process technology using silicon is well mastered. The use of other semiconducting materials such as gallium arsenide (GaAs) or cadmium telluride (CdTe) is also well known. In the industrial series production of thin-film solar modules, the pentenary semiconductor copper indium (gallium) sulfur (selenium), typically abbreviated Cu(In,Ga)(S,Se)₂, which belongs to the group of chalcopyrite compound semiconductors, has become particularly important.

Conventionally, most commercially available solar modules are produced by laminating solar cells between a front side glass sheet and a rear side support structure such as another glass sheet or a metal sheet. The solar cells in the solar module are generally electrically interconnected with each other, whereby an electric connection of the interconnected solar cells to the outside of the solar module may be established via one or more junction boxes. Solar modules usually have a planar structure with a predefined standard size. Typically, such standard size is 2 m² or less in order to, inter-alia, enable simple handling of solar modules such as manual handling by a single technician. These solar modules are well suited for installation, inter alia, on buildings or vehicles or in solar farms.

In view of the desire to generate sustainable energy and to reduce carbon dioxide (CO₂) emissions caused by fossil fuels, a strong increase in the number of solar modules is currently being observed. Most of the PV power generation comes from large power plants and, secondly, from solar modules added on roof tops. One of the biggest sources of CO₂ emission is the transportation sector.

The permanent installation of solar modules often requires a substantial amount of manual labour at an external site, i.e., not at the PV components supplier's site, especially when installing lightweight solar modules on an industrial roof or a noise barrier system. This also applies to the installation of solar modules on vehicles such as busses, trucks or trailers which are often done at the vehicle owner's site. Typically, the PV system includes solar modules, cabling, connectors and additional power electronic units such as an inverter, an MPP (Maximum Power Point)-tracking charge controller or MPP-central processing unit for providing the electric power with high efficiency, e.g., to a battery.

Further, for the application of solar modules often special safety requirements apply, particularly for passenger transportation vehicles such as city buses or long distance coaches. Specifically, for PV systems on vehicle exterior surfaces often low voltage systems are requested. The maximum voltage must be below a certain threshold, usually below 60 V. For solar modules based on silicon wafer cells this requirement implies that only a maximum of 70 to 80 individual solar cells can be connected in series, whereas the size of the solar cells have a standard format. Therefore, several strings of solar cells within the solar modules or several solar modules must be connected in parallel to achieve sufficient electric power. For applications of PV systems to facades of buildings or the exterior of vehicles the partial shading of the solar irradiation is much more likely and more critical than for PV farms. The moving vehicles will not be oriented in optimal orientation and angle towards the sun. Other vehicles, buildings, traffic infrastructure or trees and mountains can cause partial shading of the solar modules. In serial connection, partial shading will result in a strong reduction of efficiency and energy yield of the PV system. Using parallel connection and multichannel MCU, the conversion efficiency of the PV system will strongly improve. For typical solar module sizes of 2 m² or less the parallel connection of solar modules to one inverter or solar charge controller or the connection of only a few solar modules each to an MCU with many channels will result in many cables for connecting the solar modules to power electronics.

The usage of individual solar modules allows for more freedom in the layout of the PV system, which is advantageous when a bus or building roof is not only one surface but is interrupted, e.g., by air condition outlet or antennas. However, the design and manufacturing of very large (e.g., larger than 2 m x 1.5 m) solar modules with cut-outs and different shapes is complex, cost intensive and may technically be not feasible.

For solar modules applied to the exterior of vehicles, the positioning and mounting of the solar modules (by glueing or mechanical means like clamping etc.), the connection of cables, their feed-through from the vehicle exterior (roof, hood, sides) to the power electronics and the fixation of cables takes long and will be difficult to be integrated in a commercial production process of a trailer, bus, or other application in terms of process cycle time. Also, the retrofit (adding solar modules on an already running vehicle, i.e., not a new one) of transportation vehicles should be as fast as possible to avoid long commercial idle times.

In addition, the labour at exterior sites is often more expensive (e.g., travel costs) and the work at external sites (customers workshops or outdoor for industrial roofs or noise barriers) is often less controllable in terms of quality.

In general, it is desirable to use PV systems in vehicles which can be installed quickly and can readily be removed for repairing, replacement or end of life recycling, which therefore significantly reduces the total costs of PV generated electricity on vehicles and reduces downtime of commercial/transportation vehicles. This also applies for the installation of PV on large industrial roofs or noise barriers. Specifically, it is desirable to reduce and facilitate the labour for connecting the solar modules with downstream power electronics. Further, it is desirable to readily adapt the layout of the installation of solar modules to specific requirements such as roofs of transportation vehicles. Further, it is desirable to transport the solar modules in a reliable, safe and easy manner.

### SUMMARY OF THE INVENTION AND OF EMBODIMENTS

The present invention is to overcome the drawbacks as detailed above. Specifically, the present invention aims at a reduction in on-site installation time, facilitated installation, shorter downtime of commercial/transportation vehicles, easy repairability and recyclability. Furthermore, the solar modules shall be readily transportable.

These and further objects are met by the subject-matter of the independent claim. Advantageous embodiments are defined in the dependent claims and are described in the following specification and visualised in the associated figures.

According to a first aspect of the present invention, a pre-assembled solar sheet for mounting on a supporting structure such as a supporting layer which forms part of an outer skin (exterior) of a vehicle or building is described.

The solar sheet comprises a carrier sheet having a first side and a second side opposite to said first side. The solar sheet further comprises one or more solar sheet units. The solar sheet units are entities of the solar sheet which are spatially and electrically separated from each other. Specifically, the solar sheet units are not electrically interconnected, but are electrically isolated from each other. In other words, each solar sheet unit is a portion or part of the solar sheet which can be individualised and, thus, can be physically separated from the remaining solar sheet units.

Each solar sheet unit comprises multiple solar modules which are attached to the support sheet on the first side thereof. Each one of the solar modules contains a solar cell arrangement having multiple interconnected solar cells, with the solar cell arrangement being interposed between outer module layers. Each one of the solar modules has electric connectors (electric module connectors) for both electric polarities that are in electric connection with the solar cell arrangement of the solar module for providing electric power generated by the solar module to the outside of the solar module, in particular, for electrically connecting the solar module with one or more further solar modules in parallel and/or in series, or for connecting the solar module to power electronics. Each solar sheet unit further comprises multiple electric conductors that are arranged on and attached to the first side of the carrier sheet (preferably between the solar modules and the carrier sheet) and/or are arranged on and attached to the second side of the carrier sheet, wherein the electric connectors of the solar modules are electrically connected to the electric conductors, such that the solar modules are interconnected in series and/or in parallel, with one end portion of each one of the electric conductors leading either to another solar module (starting from the solar module it is electrically connected to) or into a common connection zone of the solar sheet unit.

In the context of this specification, the solar sheet is a pre-assembled solar sheet, i.e., it can be used as a pre-fabricated product for further usage.

In the context of this specification, each of the solar modules is a final product for further usage, i.e., the carrier sheet is not part of the solar modules. Specifically, the carrier layer may not be considered as an outer layer of the solar modules. Instead, each solar module has outer layers such as a front side glass sheet and a rear side support structure such as another glass sheet or a metal sheet or a polymeric layer.

According to a second aspect of the invention, a solar sheet arrangement is described. The solar sheet arrangement comprises a supporting structure, particularly a supporting layer which forms part of an outer skin of a vehicle or building. The solar sheet arrangement further comprises a solar sheet unit of a pre-assembled solar sheet according to the invention as disclosed herein, which is mounted to the supporting structure.

In one preferred embodiment, the carrier sheet is attached to the supporting structure in such a manner that a free intermediate space is created between the second side of the carrier sheet and the supporting structure and the electrical conductors are attached on the second side of the carrier sheet in the intermediate space.

In the context of this specification, the term "vehicles" mean all kinds of vehicles like buses, trucks, trailers, vans and passenger cars. The term "buildings" is meant in a general sense comprising houses and all kinds of infrastructural buildings like noise barriers, covered bridges etc. Particularly, the invention can be very useful for large flexible lightweight PV systems on large industrial roofs, on roofs for covered parking lots, covered pathways or covered bridges and for the attachment of PV on other building structures like noise barriers.

According to a third aspect of the invention, a method for producing a solar sheet for mounting on a supporting structure according to the invention and as disclosed herein is described. The method comprises, preferably in the indicated order:
- providing a carrier sheet having a first side and a second side opposite to the first side,
- producing one or more solar sheet units, which for each solar sheet unit comprises:
   i) providing multiple electric conductors,
   ii) attaching said electric conductors to said first side and/or to said second side of said carrier sheet,
   iii) providing multiple solar modules,
   iv) attaching the solar modules to the carrier sheet on the first side,
   v) electrically connecting the electric connectors of the solar modules to the electric conductors such that the solar modules are interconnected in series and/or in parallel,
wherein one end portion of each one of said electric conductors is led to another solar module or into a common connection zone of said solar sheet unit.

Alternatively, the method comprises, preferably in the indicated order:
- providing a carrier sheet (2) having a first side (A) and a second side (B) opposite to said first side,
- producing at least one solar sheet unit (100),
comprising:
i') providing multiple electric conductors (4) and providing multiple solar modules (3),
ii') electrically connecting said electrical connectors (15) of said solar modules (3) to said electrical conductors (4),
iii') attaching a first one of said solar modules (3) to said carrier sheet (2) on said first side (A),
iv') arranging said electric conductors (4) of the solar module (3) on and attaching to said first side (A) and/or arranging said electric conductors (4) on and attaching to said second side (B), wherein one end portion of each one of said electric conductors (4) lead to another solar module (3) or into a common connection zone (6) of the solar sheet unit (100),
v') repeating steps iii') and iv') until all solar modules (3) and all electric conductors (4) are attached such that said solar modules (3) are interconnected in series and/or in parallel.

According to a fourth aspect of the invention, a method for producing a solar sheet arrangement according to the invention and as disclosed herein is described. The method comprises, preferably in the indicated order:
- providing a supporting structure, in particular a supporting layer which forms part of an outer skin of a vehicle or building,
- providing at least one solar sheet unit of a pre-assembled solar sheet according to the invention and as disclosed herein,
- mounting the solar sheet unit to said supporting structure, in particular by means of a glue.

In the context of this specification, each solar module can be removed from the underlying supporting structure (e.g., vehicle exterior, building roof, building facade) without compromising the operation of the vehicle or building in terms of mechanical or electric functionality and safety.

Briefly summarised and without limiting the scope of the invention, basic ideas underlying embodiments of the invention and associated possible advantages will be roughly described as follows:
As indicated above, it may be intended to cover an entire surface of the roof of a vehicle or building of several meters in length with solar modules, which results in many cables and, thus, electric connection with power electronics can cause much labour. Further, often there are specific constraints in terms of non-coverable zones requiring a specific layout of the solar modules which may be troublesome. It is therefore suggested herein to use a solar sheet with one or more solar sheet units on a carrier sheet, with each solar sheet unit comprising multiple solar modules, together with electric conductors for interconnecting the solar modules. Specifically, the electric conductors are configured such that end portions of each one of the electric conductors lead either to another solar module or into a common connection zone of the solar sheet unit. The common connection zone strongly facilitates connection of the electric conductors to power electronics as the electric conductors are located in one common location and, thus, can be readily passed through one or more openings of the planar underlying structure.

Further, as being flexible, the solar sheet may be bent into a rolled configuration or may be folded into a folded configuration, so that it can be provided in a space saving manner and may be easily transported and handled. Alternatively, the solar sheet may be cut into pieces, with each piece comprising one or more solar sheet units, wherein the pieces can be stacked for easy handling and transport. On the other hand, the solar sheet can easily be mounted on the underlying supporting structure such as the roof of a vehicle or building by continuously unwinding or unfolding the solar sheet in wounded or folded configuration. These are major advantages of the claimed invention.

In the following, possible features of embodiments of the invention and associated possible advantages will be described in more detail.

In the solar sheet, in general, the carrier sheet may be made from any material on which the solar modules can be attached. The carrier sheet may be configured to be rigid or flexible. Specifically, the carrier sheet may be made of any material and may be provided with a geometry such as to, on the one hand, enable a sufficient flexibility and bendability while, on the other hand, sufficiently supporting and stabilising the solar modules against e.g. excessive bending thereof. The carrier sheet must have sufficient strength and tear resistance to carry the weight of the solar modules during pre-assembly, transport and mounting. The material and thickness of the carrier sheet have to be selected based on the total size, weight of the solar sheet unit, the supporting structure of the application (trailer roof, industrial roof, etc) and the mounting processes (compatibility with the glueing etc).

In one embodiment the thickness of the carrier sheet is from 50 to 2000 µm, but can also be thicker when the application requires it.

The material of the carrier sheet is preferably based on polymers like extruded foils or sheets of thermoplastics (e.g. PVC) or elastomers (e.g. EPDM), polymer composites with glass fiber or carbon fibers, or textile materials, fabrics, but can also include thin metal layers or naturally grown fibers. In one embodiment, the carrier sheet is a polymer foil. Considered materials could be materials typically used for truck planes (e.g. PVC-coated polyester or polyethylene fabric) or for building roofs (like EPDM) but also other polymer foils and composites, metal laminates or naturally grown fibers can be used. The material should be tear resistant, weather resistant, lightweight, and low cost. If flexible, the carrier sheet should be reversibly bendable, i.e. deformable without cracking or irreversibly changing its structure, to a curvature radius of less than 2 m, preferably less than 1 m or even less than 0.6 m. Basically, the carrier sheet shall be a large, flexible, lightweight, and robust support sheet.

The carrier sheet has lateral dimensions which are typically significantly larger than the dimensions of a conventional solar module. In one embodiment, the length of the carrier sheet is at least 2 m, preferably at least 3 m, at least 5 m or even at least 10 m. A width of the carrier sheet may depend on dimensions in a specific application in which the solar sheet is to be used. For example, such width may be larger than 30 cm, larger than 50 cm or even larger than 1 m or larger than 2,5 m. Preferably, the width is smaller than 10 m, smaller than 6 m or even smaller than 4 m. Accordingly, an area of the solar sheet may be larger than 2 m², preferably larger than 5 m² or even larger than 10 m². As an example, for the application for vehicles, due to street regulations vehicles have a width of maximum 2.5 m and a maximum length of 25 m.

The solar modules can be conventional solar modules such as, but not limited to, light-weight, flexible or semi-flexible solar modules. The solar cells of the solar modules can basically be of any design. According to one embodiment, the solar cells are wafer-based solar cells and are, in particular, solar cells based on monocrystalline or polycrystalline silicon, which are electrically connected on the front or rear side by interconnectors. According to a further embodiment, the solar cells are thin-film solar cells and are in particular solar cells based on copper indium gallium sulfur (selenium) CIGS (Se), cadmium telluride (CdTe), perovskites or amorphous silicon. The solar cells can be series-connected as wafer-based solar cells with interconnectors, or series-connected as thin film solar cells in monolithic integrated form. Preferably, the solar cells are mono- or polycrystalline silicon based solar cells serially connected by interconnectors. Preferably, the photovoltaically active absorber layer comprises or consists of a chalcopyrite semiconductor, which is advantageously a ternary I III-VI compound semiconductor from the group copper indium/gallium disulfide/diselenide (Cu(In,Ga)(S,Se)₂). In the above formula, indium and gallium may be present alone or in combination. For example, the photovoltaically active absorber layer may also be made of cadmium telluride (CdTe).

Consistent with common usage, the term "solar cell" includes a front electrode, a photovoltaically active absorber, and a back electrode. For applications with high demands on power density (solar cell efficiency) and high visual-aesthetic requirements, such as integration in a vehicle, back-contacted solar cells can also be used advantageously, in which the contacts of both polarities and the pn junctions are arranged on the rear side facing away from the light. In thin-film solar cells, the front electrodes are connected in series with the respective adjacent back electrodes in integrated form. In thick-film solar cells, interconnectors are provided for the electrical connection of the front electrodes with the respective adjacent back electrodes.

The solar cells may, e.g., be fabricated based on crystalline silicon wafers. Such wafer-based Si-PV cells may generally have e.g. a high efficiency of more than 15% (i.e. e.g. between 17% and 26%) and a high reliability. Such solar cells typically have lateral dimensions of between 50 x 50 mm² and 300 × 300 mm², mostly between 150 x 150 mm² and 200 × 200 mm², with a square shape, a rectangular shape, a round shape, a semi-round shape or any other shape. Furthermore, such PV cells generally have a thickness of more than 50 µm, typically between 100 µm and 300 µm. Having such thickness, the PV cells are relatively rigid, i.e. they may generally not be bent into small bending radii of e.g. less than their lateral dimensions as they will otherwise break. Generally, it may be assumed that, depending on a cell size, bending radii of less than 60 cm, less than 80 cm, less than 90 cm or less than 100 cm should be avoided.

Each solar cell comprises electric contacts. The electric contacts of neighbouring solar cells may be interconnected via electric connections such that these solar cells may be electrically connected in series, in parallel or in any combination of series and parallel connections. The electric connections may be provided by one or more electrically conducting ribbons and/or one or more copper solderings between two adjacent solar cells. A plurality of interconnected solar cells forms part of a solar cell arrangement, sometimes also referred to as solar cell string. Furthermore, the solar cell arrangement may comprise additional components such as external contacts via which the solar cell arrangement may be connected to an external electric circuit, such external contacts sometimes being referred to as forming part of a junction box. Additionally, the solar cell arrangement may comprise for example bypass diodes or other electric components. Optionally, one or more release loops for releasing mechanical tensions may be included in the solar cell arrangement.

Preferably, the solar modules are produced by laminating solar cells between a front side glass sheet and a rear side sheet. The front side sheet needs to be transparent. Both the front and the rear side sheet protect the solar cells against mechanical impact, humidity, and other environmental stresses during outdoor operation. For standard applications the front sheet is often made of glass and the back sheet is made of glass or a polymer material. For light-weight solar modules glass is often replaced by polymer materials like ETFE, PET or polycarbonate.

A laminated solar module comprises an encapsulation into which the solar cells, the electric interconnections and possibly other components are embedded. Typically, the encapsulation comprises or consists of a thermoplastic or thermosetting polymer such as EVA (Ethylene Vinyl Acetate) or POE (Polyolefin Elastomer). The encapsulation may be composed of a first lamination foil (which may also be referred to as front side polymeric lamination foil) and a second lamination foil (which may also be referred to as rear side polymeric lamination foil) enclosing the plurality of solar cells from opposite sides. In a lamination procedure, such front and rear side encapsulation foils may be heated beyond a glassifying temperature of the polymeric material while being pressed against each other. Accordingly, the sticky viscous or even partially molten polymer material of both encapsulation foils may combine in regions where the foils contact each other and/or may glue to solar cells interposed between the encapsulation foils. Accordingly, upon cooling down and solidifying the polymer material, the solar cells and the polymer material of the lamination foils may form an encapsulation.

The solar modules can, e.g., be solar modules of standard sizes, like 2 m × 1 m, 1 m × 1 m or any suitable size.

Preferably, the solar modules are, independently from the supporting structure, weatherproof and sufficiently robust, and have electric outlets (connectors) for both polarities, e.g., ribbons, insulated cables or a connection box.

The solar modules of one solar sheet unit can have the same or different sizes. The solar modules can be arranged in landscape and/or portrait format. Several solar modules can be mounted in rows and columns.

Specifically, the solar modules can be arranged in a plurality of segments, with one or more solar modules being included in each segment, wherein a folding line is defined between two adjacent segments so that the solar sheet can be folded at the folding lines to obtain a folded configuration.

In one embodiment useful particularly for vehicles the total system voltage of one solar sheet unit is below 60 Volts: i.e. the maximum open circuit voltage of each module or the maximum open circuit voltage of all strings of solar modules that are connected in series is always below 60 V. In some cases, it can be useful to even limit the total system voltage to 48 V or even to 24 V if the solar system charges a low voltage vehicle battery.

The solar modules are fixedly attached to the carrier sheet. In general, any means for fixation may be used. Preferably, the solar modules are removably attached to the carrier sheet, i.e., the solar modules can be removed from the carrier sheet without destroying the carrier sheet so that individual solar modules can be readily repaired or replaced. In one embodiment, the solar modules are attached to the carrier sheet by means of one or more fixation means selected from the group consisting of a glue, an adhesive material and a Velcro fastening. Specifically, the solar modules may be fixed to the carrier sheet by glueing, plastic welding, roll lamination, mechanical fixture or other suitable means. In general, the solar modules are attached with their rear sides (i.e., not sunny sides) to the carrier sheet so that light such as sunlight may hit on the active areas of the solar modules for the photovoltaic generation of electric power.

Each solar sheet unit comprises multiple electric conductors, which are arranged on and attached to the first side of the carrier sheet between the solar modules and the carrier sheet and/or are arranged on and attached to the second side of the carrier sheet. The electric conductors are electrically connected to the electric connectors of the solar modules, such that the solar modules are interconnected in parallel and/or in series. If the electric conductors are arranged on the second side of the carrier sheet, it may be preferable to lead the electric conductors through holes of the carrier sheet for electrically connecting to the electric connectors of the solar modules.

In one preferred embodiment, the electric conductors are configured as flat conductors (flat cables). A flat conductor (also called foil conductor or ribbon conductor) is an electrical conductor whose width is significantly greater than its thickness. The flat conductor is preferably designed to be so thin (i.e., the thickness is so small) that it is flexible and bendable.

In one embodiment, each flat conductor comprises a metal foil, particularly preferably comprising a strip or ribbon-shaped metal foil. The metal foil may comprise or consists of a copper foil, an aluminium foil, a stainless steel foil, a tin foil, a gold foil or a silver foil. The metal foil may also contain or consist of alloys with said metals. Advantageously, the metal foil may be tinned in sections or completely. This is particularly advantageous in order to achieve good solderability with simultaneous corrosion protection.

In one embodiment, the flat conductors have a thickness of 100 µm to 2000 µm, preferably less than 1000 µm. Such thickness is particularly suitable for positioning the flat cables between the solar modules and the carrier sheet or between the carrier sheet and the supporting structure (i.e., the outer skin of a vehicle or building).

In one embodiment, the flat conductors have a width of from 0.5 mm to 100 mm, preferably from 1 mm to 50 mm. Such widths are particularly suitable for achieving sufficient current-carrying capacity in conjunction with the above-mentioned thicknesses. The width of the flat conductors can be constant or vary in width. It is understood that the length, width and thickness of the flat conductors can be adapted to the requirements of the particular case.

Advantageously, each flat conductor has an insulation layer that is firmly connected to the metal foil. The insulation layer or film preferably comprises or consists of polyimide or polyether, particularly preferably polyethylene terephthalate (PET) or polyethylene napthalate(PEN). The insulation layer may also consist of an electrically insulating lacquer, preferably a polymer lacquer, applied to the flat conductor, for example by spraying or dipping the flat conductor into the lacquer. The insulating layer may also contain or consist of thermoplastics and elastomers such as polyamide, polyoxymethylene, polybutylene terephthalate, or ethylene-propylene-diene rubber. Alternatively, potting materials such as acrylate or epoxy resin systems can be used as insulation layers. Insulation layers or films may, e.g., have thicknesses of from 10 µm to 300 µm. The insulation layer is advantageously bonded to the metal foil via an adhesive layer. Such insulation layers are particularly suitable for electrically insulating the flat conductor and mechanically stabilizing it and protecting it from mechanical damage and corrosion. Those skilled in the art will appreciate that no insulation layer or other electrical insulation is present in regions for electrically connection the flat conductors to the electric connectors of the solar modules. Insulation-free connection areas can be achieved by windowing techniques during manufacture or by subsequent removal, for example by laser ablation or mechanical removal.

Accordingly, instead of using standard cables with circular cross section (of typically 4 - 6 mm²), flat conductors with a same cross section but with a rectangular shape with a total thickness of less than 3 mm, preferably less than 2 mm or even less than 1 mm, including insulation, may be used. In one embodiment, the flat conductors are made of a single insulated metal ribbon, or of several thin wires in one insulation, or are made as multi-wire cables where each wire is insulated.

In the solar sheet, the electric conductors, preferably flat conductors, can be guided in three different ways:
i) on the first side of the carrier sheet next to the solar modules, and/or
ii) under the solar modules, but on the sunny side (first side) of the carrier sheet, and/or
iii) they can be fed through holes in the carrier sheet and guided on the inner side (second side), i.e. between carrier sheet and application surface (vehicle roof, vehicle sides, building roof, noise-barrier structure).

The latter two are advantageous because the cables are for the most part of their length hidden and protected by the solar modules or the carrier sheet.

In one embodiment of the solar sheet, the solar modules are attached to the carrier sheet in such a manner that a free intermediate space is created between each one of the solar modules and the support sheet. Advantageously, electric conductors, preferably flat conductors, can readily be guided through the intermediate space between the solar modules and the carrier sheet.

In each solar sheet unit, the end portion of each one of the electric conductors, preferably flat conductors, leads into a common connection zone of the solar sheet unit. In general, the common connection zone is a region of the solar sheet unit where the end portions of the electric conductors are led together for further handling. In one embodiment, the common connection zone is arranged in an edge region of the solar sheet unit. In another embodiment, the common connection zone is placed below one of the solar modules. This embodiment is particularly advantageous in case of space restrictions, e.g., on vehicle roofs when all accessible areas should be covered with solar modules for highest energy generation.

In one embodiment, the common connection area of each solar sheet unit comprises one connection box or multiport connector that is preferably attached to the carrier sheet. The connection box or multiport connector has multiple outlet sockets to which all electric conductors are electrically connected. The outlet sockets may be used to connect the electric conductors to external power electronic units such as to the MCU or the MPP-charge controller or the inverter.

In one embodiment, the end portion of each of the electric conductors is equipped with a single port connector, i.e., plug or adaptor (from flat cable to a standard connector like MC4 or others). In one embodiment, the end portion of each electric conductor is fixedly attached to the carrier sheet, e.g., by glueing or mechanical clamping. In one embodiment, the end portion of each electric conductor is not fixedly attached to the carrier sheet which may be advantageous if the end portions of the electric conductors need to be guided through a hole in the supporting structure such as building or vehicle roof.

The electrical connection can also be much faster using suitable connectors as much fewer components need to be connected: in best case only one cable bundle from the common connection area leads to the external power electronics such MCU or inverter.

In one embodiment, by using thin solar modules, electric conductors, and connectors a total height (thickness) of the solar sheet is below 6 mm, below 3 mm or even below 2 mm. For a total thickness below 3 mm, special light weight solar modules are available which can reach thicknesses below 2 mm and a weight below 5 kg/m² or even below 2 kg/m². By reducing the thickness of the solar modules also the weight of the complete pre-assembled solar sheet can be reduced.

Lateral dimensions, i.e., a width, of the solar sheet may, e.g., range from about 0.3 m to 10 m, particularly from 0.5 m to 3 m.

In one embodiment, the solar modules contained in the solar sheet cover a substantial portion thereof, i.e., for example more than 30%, more than 50%, more than 70% or even more than 90%, of an entire area of the solar sheet.

In one embodiment, the carrier sheet has one or more marginal cut-outs and/or one or more interior cut-outs. Accordingly, the solar sheet can readily meet specific constraints regarding the supporting structure. Stated more particularly, if areas of the vehicle exterior or building roof need to be used for other purposes (air conditioning, glass ceilings, escape windows, antennas etc), the solar sheet unit can have cut-outs without carrier sheet, modules and cables. For example, the pre-assembled solar sheet unit can have cut-outs from the edges resulting in a U- shape or an H- shape of the carrier sheet or any other form which has a continuous area, or the cut-outs are in the interior of the carrier sheet in an area without modules and cables. Larger vehicle roofs often have beadings which are linear protrusions or depressions within the roof for the increase of stiffness and the decrease of noise and vibrations. In one embodiment, light-weight polymer paddings are attached to the rear side of the carrier sheet which match the height profile of the vehicle roof such that the carrier sheet, the modules and the cables are not bent above the beadings.

In one embodiment, the carrier sheet has a bending stiffness such that the carrier sheet is a flexible carrier sheet. In one embodiment, preferably combined with a flexible carrier sheet, the solar modules have a bending stiffness such that the solar modules are configured as flexible solar modules, in particular semi-flexible solar modules.

A flexible (semi-flexible) solar module can be bent to a certain maximum degree, typically with a minimum bending radius of 1 m. There is no sharp distinction between flexible and semi-flexible, however. For highest power density at low cost, silicon wafer-based semi-flexible modules are preferred. Other technologies like thin-film CIGS, CdTe or perovskites can be used if focus is on lower stiffness (higher mechanical flexibility and smaller maximum bending radius).

By having a flexible carrier sheet and flexible solar modules, the solar sheet can be bent into a rolled configuration. The solar sheet may be bent into at least one entire winding, preferably into multiple windings, such that opposing end portions of the solar sheet overlap each other and the rolled overall-stack may be handled as a stable, substantially cylindrical unit. Preferably, the solar sheet is wound into spirally rolled configuration.

In one embodiment, the solar sheet is bent into the rolled configuration by winding the solar sheet onto a cylindrical drum (spool). In other words, a cylindrical drum may be provided and the solar sheet may be adjoined to the spool and may successively be wound onto the drum. For example, a quasi-continuous process may be established in which a portion of the solar sheet is wound onto the drum. In such a process, the drum may be rotated and the solar sheet may be continuously or in a step-like manner supplied to the drum. The drum may define an inner geometry and, particularly, an inner radius of the rolled configuration into which the solar sheet is wound.

Preferably, the inner diameter of the rolled configuration is set such that none of the solar cells is excessively bent upon bending the solar sheet into the rolled configuration. For such purpose, the minimum inner diameter of the roll configuration should be at least 0.6 m, preferably at least 0.7 m, at least 0.8 m, at least 0.9 m or even at least 1 m. Therein, half of such minimum inner diameter generally corresponds to a curvature radius to which the solar cells are bent. Thus, a risk of solar cell breakage may be minimised.

According to an embodiment of the solar sheet, the bending stiffness of the flexible carrier sheet is configured such that the solar sheet can be folded between adjacent solar modules. In such embodiment, the solar modules need not necessarily be flexible. In one embodiment, the solar sheet is folded in-between solar sheet units and/or in-between solar modules of individual solar sheet units, provided that solar modules are not folded. Specifically, the solar modules can be arranged in a plurality of segments, with one or more solar modules being included in each segment, wherein a folding line is defined between two adjacent segments so that the solar sheet can be folded at the folding lines to obtain a folded configuration.

In one embodiment, the folding is a spiral folding with one end of the solar sheet located in the centre of the folded stack and the other end of the solar sheet on the outside of the folded stack. In one embodiment, the spacing between the solar modules and the length of the solar modules varies in such a way that the solar sheet can be folded in a spiral folding, i.e., the distance between the folding lines increases from inside to outside of the folding stack, i.e., from one end of the solar sheet to the other end.

In order to then mount the solar sheet or solar sheet unit to a supporting structure, the solar sheet or solar sheet unit may be unrolled from its rolled configuration or may be unfolded from is folded configuration and may then for example be joined to a planar or slightly curved supporting substrate.

Above considerations apply also to the case of having a single solar sheet unit instead of a solar sheet which can have one or more solar sheet units.

Further, in case the solar sheet comprises multiple solar sheet units, the solar sheet may be cut into two or more solar sheet pieces, with each solar sheet piece comprising one or more solar sheet units, followed by stacking the solar sheet pieces.

Providing a flexible carrier sheet and flexible solar modules, in one embodiment of the method for producing a solar sheet for mounting on a supporting structure according to the invention, the method comprises one or more of the following steps:
- winding the solar sheet into a rolled configuration, in particular spirally rolled configuration,
- winding the pre-assembled solar sheet onto a cylindrical spool,
- single or multiple folding of the pre-assembled solar sheet into a folded configuration having one or more folding areas between adjacent solar modules, in particular a spirally folded configuration.

Further, in one embodiment of the method for producing a solar sheet for mounting on a supporting structure according to the invention, the method comprises the step of cutting the solar sheet into two or more solar sheet pieces, with each solar sheet piece comprising one or more solar sheet units, and stacking the solar sheet pieces.

By stacking, folding or rolling the pre-assembled solar sheet the solar sheet may readily be shipped to the customer or construction site, respectively.

In one embodiment of the method for producing a solar sheet arrangement according to the invention, the pre-assembled solar sheet or solar sheet unit is continuously provided by unrolling the solar sheet or solar sheet unit from a rolled configuration or by unfolding the solar sheet or solar sheet unit from a folded configuration. In one embodiment, before mounting to a supporting structure, a solar sheet unit is cut from the pre-assembled solar sheet at the installation site.

At the installation site, the pre-assembled solar sheet or solar sheet unit is mounted to the supporting structure, preferably of a vehicle or building, and the electric conductors are connected at the common connection area to external power electronics such as an MPPT charge controller, an MCU or inverter. An inverter supplies AC power and a charge controller is an DC/DC converter that provides the necessary voltage and current to charge a battery. An MCU has several (i.e., more than one) DC/DC channels for MPP tracking within one device and provides one or two output channels with the appropriate current/voltage, for example a high voltage (400 V) to charge the battery for an electric vehicle or a low voltage to supply the charging of batteries of low voltage systems.

On the vehicle or building the carrier sheet is not necessarily continuous, but can be separated. For shortest mounting times the least possible number of pre-assembled solar sheets units with a high number of modules on each solar sheet unit should be used. On vehicles, like buses, one solar sheet unit may not be possible due to other installations like an air conditioning unit or a glass roof. However, also individual cut-outs can be considered.

The pre-assembled solar sheet (or solar sheet unit) can, e.g., be mounted to a truck or bus trailer, a cargo box truck or van, a bus roof, an industrial roof, a roof of a covered parking lost, covered pathway or covered bridge or a noise barrier by glueing, adhesive taping, plastic welding, riveting, clamping, screwing, or any other mechanical means. The mounting aims for a permanent fixation with the possibility for repairing in case of solar module failure. Due to the already pre-assembled solar sheet and solar sheet units, respectively, the mounting process at the customer can now take significantly less time than in by mounting individual solar modules.

For glueing the pre-assembled solar sheet or solar sheet unit on a large vehicle or building roof several approaches can be used. In one embodiment, the carrier sheet has a continuous adhesive rear surface which is covered with a liner. Before glueing, the liner has to be removed. In one embodiment, the carrier sheet contains a double-sided tape that is already attached to the carrier sheet on the rear side. Before fixation the liner has to be removed. Alternatively, a double-sided tape is attached to the vehicle or building roof. Alternatively, glue is dispensed on the vehicle or roof surface. Alternatively, for easy replacement a hook- and- loop fastener tape can be considered. In this case, the closed tape should be placed on the vehicle or building roof, the supporting foil is then placed on top.

In one embodiment of the method for producing a solar sheet arrangement according to the invention, the solar sheet or solar sheet unit is mounted to the supporting structure in such a manner that a free intermediate space is created between the solar sheet or solar sheet unit and the supporting structure, so that electric conductors can readily be guided between the carrier sheet or solar sheet unit and the supporting structure.

The solar sheet of the invention has the advantage of low-costs and high flexibility in production and mounting onto a supporting structure at the installation site. Specifically, the pre-assembled solar sheets can be produced in a fast and efficient production process. At a separate location, for example at the customer's site, the pre-assembled solar sheets (solar sheet units) can be mounted to the exterior of a vehicle or building in a very short time.

It shall be noted that possible features and advantages of embodiments of the invention are described herein partly with respect to a solar sheet and solar sheet arrangement and partly with respect to methods for the production thereof. One skilled in the art will recognize that the features may be suitably transferred from one embodiment to another and features may be modified, adapted, combined and/or replaced, etc. in order to come to further embodiments of the invention.

### BRIEF DESCRIPTION OF THE DRAWINGS

In the following, advantageous embodiments of the invention will be described with reference to the enclosed drawings. However, neither the drawings nor the description shall be interpreted as limiting the invention.
- Fig. 1: is a top view of an exemplary embodiment of a pre-assembled solar sheet according to the invention,
- Fig. 2A: is a sectional view of a further exemplary embodiment of a pre-assembled solar sheet of Fig. 1 in a spirally folded configuration,
- Fig. 2B: is a sectional view of an exemplary solar sheet arrangement comprising the spirally folded solar sheet of Fig. 2A in a partly unfolded configuration,
- Fig. 3: is a sectional partial view of a further exemplary embodiment of a solar sheet according to the invention,
- Fig. 4: is a sectional partial view of a further exemplary embodiment of a solar sheet arrangement according to the invention,
- Fig. 5: is a sectional view of a further exemplary embodiment of the pre-assembled solar sheet according to the invention partly wound on a cylindrical drum,
- Fig. 6: is a top view of a further exemplary embodiment of a pre-assembled solar sheet according to the invention,
- Fig. 7: is a top view of a further exemplary embodiment of a pre-assembled solar sheet according to the invention,
- Fig. 8: is a top view of a further exemplary embodiment of a solar sheet arrangement according to the invention comprising a pre-assembled solar sheet,
- Fig. 9: is a flowchart illustrating an exemplary embodiment of a method for producing a solar sheet (steps I through III) and an exemplary embodiment of a method for producing a solar sheet arrangement (steps I through VI).

The figures are only schematic and not to scale. Same reference signs refer to same or similar features.

### DESCRIPTION OF PREFERRED EMBODIMENTS

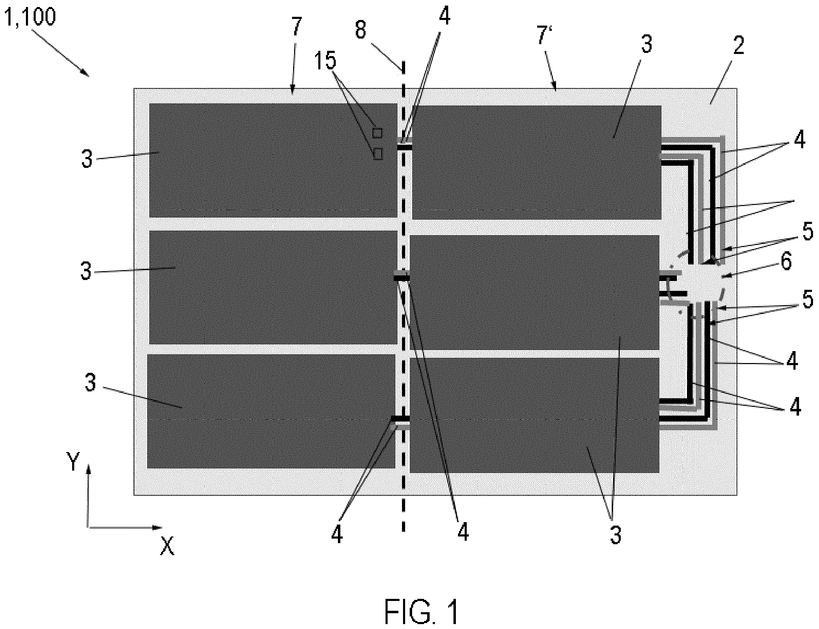

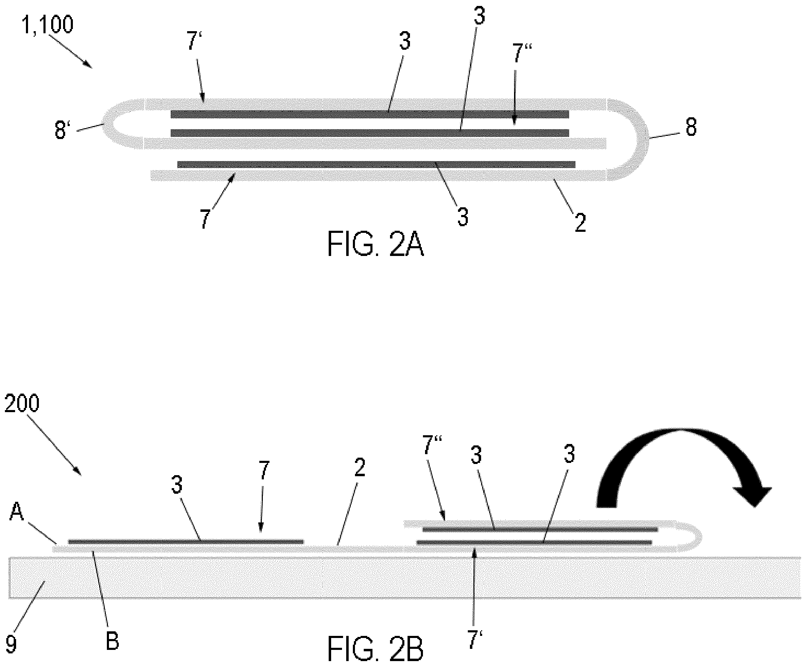

Reference is made to Figs. 1, 2A and 2B depicting in Fig. 1 a top view of an exemplary embodiment of a pre-assembled solar sheet according to the invention, in total denoted by the reference sign 1, in Fig. 2A a sectional view of a further exemplary embodiment of the pre-assembled solar sheet in a spirally folded configuration, and in Fig. 2B a sectional view of an exemplary solar sheet arrangement comprising the spirally folded wound pre-assembled solar sheet of Fig. 2A in a partly unfolded configuration.

In these embodiments, the pre-assembled solar sheet 1 comprises one solar sheet unit so that the solar sheet 1 is identical to the solar sheet unit 100. However, alternatively, the solar sheet 1 may comprise multiple solar sheet units 100 (not illustrated).

The solar sheet 1 comprises a flexible carrier sheet 2 that has a first side A (sunny side) and a second side B opposite to the first side A (see Fig. 2B). The carrier sheet 2 is rectangular in shape and has a longer edge defining a longitudinal direction X and shorter edge defining a transverse direction Y as indicated by arrows in Fig. 1. The carrier sheet 2 may, e.g., be a polymer foil having a thickness in the range from 50 to 2000 µm.

The solar sheet 1 further comprises multiple solar modules 3 that are attached with their rear sides to the carrier sheet 2 on the first side A thereof, e.g., by means of a glue. The solar modules 3 may be light-weight, semi-flexible solar modules. In the embodiment of Fig. 1, the solar sheet 1 has six solar modules 3 arranged in three rows aligned along the transverse direction Y, with each row having two solar modules 3 aligned along the longitudinal direction X. Each solar module 3 is rectangular in shape, with its longer dimension (length) extending in longitudinal direction X and its shorter dimension (width) extending in transverse direction Y.

Further, each solar module 3 has electric connectors 15 of both polarities for electrically connecting the solar module 3 with the exterior. In Fig. 1, in the left upper solar module 3 two electric connectors 15 of the solar module 3 are schematically illustrated. The electric connectors advantageously are fed through the rear side of the solar module. Alternatively, the electric connectors come out of the edges of the solar module or from a position on the front side close to the edges (not illustrated). The electric conductors 4 are electrically connected to the electrical connectors 15 of the solar modules 3, such that the two solar modules 3 of each row are connected in series, with the rows being in parallel electric configuration. Respective end portions 5 of the electric conductors 3 are led to a common connection zone 6 for further connection to external power electronics at the installation site. In one embodiment, the end portions 5 of the electric conductors 3 are connected to a common connection box having plural outlet sockets or alternatively to a common connector plug (not illustrated). Alternatively, the end portions 5 of the electric conductors 3 may be connected to single (individual) plugs (not illustrated).

The end portions 5 of the electric conductors 3 may be attached to the carrier sheet 3 or, alternatively, may be loose with regards to the carrier sheet 3. In this embodiment, the common connection zone 6 is arranged at an edge region of the carrier sheet 3, e.g., in front of the middle row, and has a dimension in the transverse direction Y that is smaller than the width of a single solar module 3.

As illustrated in Fig. 1, the solar modules 3 can be considered to be arranged in two segments 7, 7' aligned in longitudinal X direction and defining a folding line 8 in-between them, with the folding line 8 extending in transverse direction Y. The solar sheet 1 can be folded at the folding line 8, i.e., between the solar modules, without damaging the solar modules 3.

The exemplary solar sheet 1 of Fig. 1 has three rows, with each row having two solar modules 3 in series-connection resulting in two segments 7, 7', but may have more than two segments 7, 7' in a similar arrangement, so that the solar sheet can have two or more folding lines, with each folding line being defined between two adjacent segments. For example, a solar sheet 1 having three segments has two folding lines between adjacent segments.

Fig. 2A illustrates a sectional view as sectioned in longitudinal direction X of a further exemplary embodiment of the pre-assembled solar sheet 1 in a spirally folded configuration. Again, solar sheet 1 and solar sheet unit 100 are identical. The solar sheet 1 differs from the solar sheet 1 of Fig. 1 by having three segments 7, 7', 7‴ resulting in two folding lines 8, 8'. Accordingly, the solar sheet 1 comprises a first segment 7, a second segment 7' and a third segment 7‴ arranged in longitudinal direction X, with a first folding line 8 in-between the first segment 7 and the second segment 7' and a second folding line 8' in-between the second segment 7" and the third segment 7‴. In the spirally folded configuration, the third segment 7" is an innermost segment, followed by the second segment 7' arranged on one side of the third segment 7" and followed by the first segment 7 arranged on the other side of the third segment 7".

Fig. 2B illustrates a sectional view as sectioned in longitudinal direction X of an exemplary embodiment of the solar sheet arrangement comprising the spirally folded pre-assembled solar sheet 1 of Fig. 2A in a partly unfolded configuration. The solar sheet arrangement is in total denoted by the reference numeral 200. Stated more particularly, in Fig. 2B the solar sheet 1 is mounted to a supporting structure 9 which is a supporting layer, e.g., a roof of a building or vehicle. The solar sheet 1 is illustrated in a partly mounted configuration, with the first segment 7 and the second segment 7' being unfolded and attached to the supporting structure 9, e.g. by means of a glue, and the third segment 7" being still folded and not yet attached to the supporting structure 9. As a next step, the third segment 7" can be unfolded and attached to the supporting structure 9 as illustrated by the bent arrow.

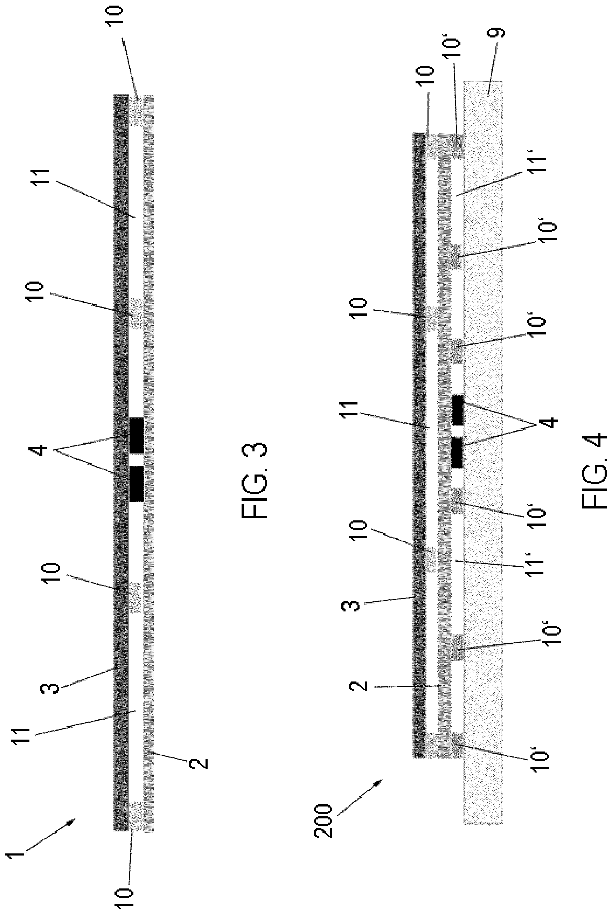

Fig. 3 is a partial sectional view as sectioned in the transverse direction Y of a further exemplary embodiment of a solar sheet 1 illustrating the specific guidance of the electric conductors 4. The partial sectional view of Fig. 3 illustrates, for the sake of simplicity, only one solar module 3 according to one row of the solar sheet 1 of Fig. 1. It is to be understood that the solar sheet 1 may include several rows as depicted in Fig. 1 so that several solar modules may be arranged side by side. In this embodiment, the solar module 3 is attached to the carrier sheet 2 by means of an adhesive 10, such that a free intermediate space 11 is created between the solar module 3 and the carrier sheet 2. As depicted, electric conductors 4 are guided through the intermediate space 11 between the solar module 3 and the carrier sheet 2 and are attached to the first side A of the carrier sheet 2. In Fig. 3, two electric conductors 4 for both polarities are connected to electric connectors 15 of the solar module 3 (not illustrated) for electrically connecting the solar module 3 with another solar module or external power electronics.

As illustrated in Fig. 4 illustrating a solar sheet arrangement 200, a rear side of a carrier sheet 2 is attached to a supporting structure 9 by means of an adhesive 10', such that a free intermediate space 11' is created between the carrier sheet 2 and the supporting structure 9. As depicted in Fig. 4, the electric conductors 4 can also be guided through the intermediate space 11' between the carrier sheet 2 and the supporting structure 9, with the electric conductors 4 being attached to the second side B of the carrier sheet 2. For electrically connecting the electric conductors 4 to the electric connectors 15 of the solar module 3 (not illustrated), the electric conductors 4 are led through a hole of the carrier sheet 2 (not illustrated).

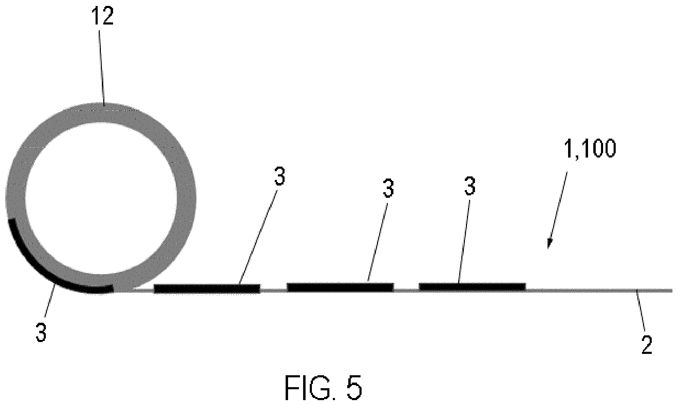

Fig. 5 is a sectional view as sectioned in the longitudinal direction Y of a further exemplary embodiment of the pre-assembled solar sheet 1 partly wound on a cylindrical drum 12 into a rolled configuration. Again, the solar sheet 1 is identical to the solar sheet unit 100, i.e. the solar sheet 1 includes only one solar sheet unit 100. Accordingly, the pre-assembled solar sheet 1 can readily be stored and transported for further usage, e.g., to an installation site. By (e.g. continuously) unwinding the rolled solar sheet 1, the solar sheet 1 can be readily mounted to the supporting structure. Fig. 5 illustrates a solar sheet 1 having five solar modules 3 in a single row. It is to be understood that more or less than five solar modules 3 in a row can be envisaged. Further, while only one row of solar modules 3 is depicted in Fig. 5 due to the longitudinal sectional view, it is to be understood that the solar sheet 1 may comprise multiple rows of solar modules 3.

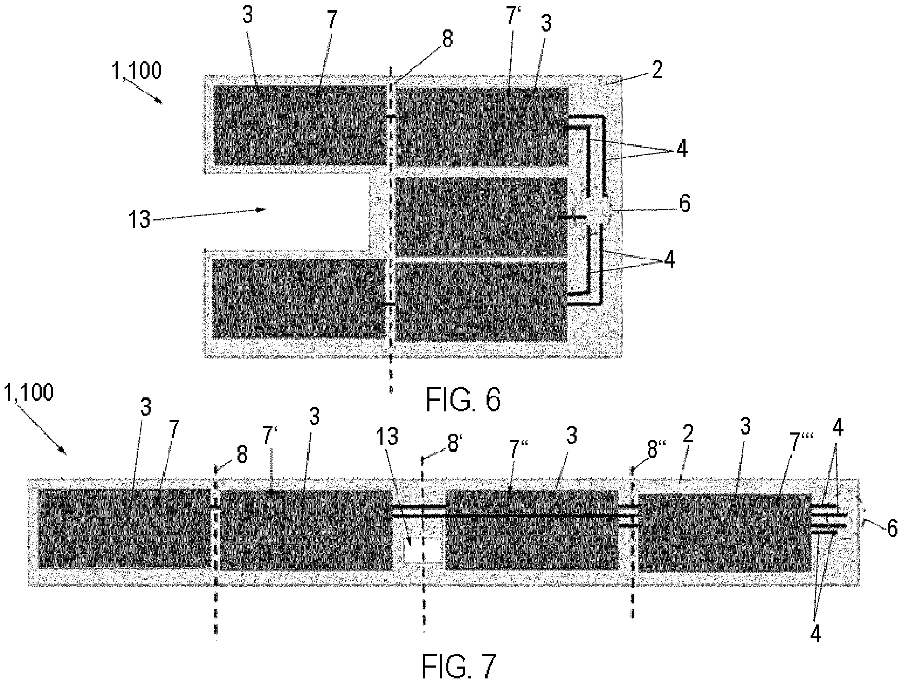

Fig. 6 is a top view of a further exemplary embodiment of a pre-assembled solar sheet 1 according to the invention. Again, the solar sheet 1 is identical to the solar sheet unit 100, i.e., the solar sheet 1 includes only one solar sheet unit 100. The solar sheet 1 differs from the solar sheet 1 of Fig. 1 by having a cut-out 13 of the carrier sheet 2 (without solar modules and electric conductors), which is a marginal cut-out starting from an edge of the carrier sheet 2 resulting in a "U"-shape of the solar sheet 1. The cut-out 13 may be positioned at a location of the supporting structure which must not to be covered by the carrier sheet such as an antenna or air conditioning outlet of the roof of a bus.

Fig. 7 is a top view of a further exemplary embodiment of a pre-assembled solar sheet 1 according to the invention. Again, the solar sheet 1 is identical to the solar sheet unit 100, i.e. the solar sheet 1 includes only one solar sheet unit 100. The solar sheet 1 has an interior cut-out 13 of the carrier sheet 2 (without solar modules and electric conductors). Further, the solar modules 3 are arranged in one row, however, are electrically connected in parallel by the electric conductors 4.

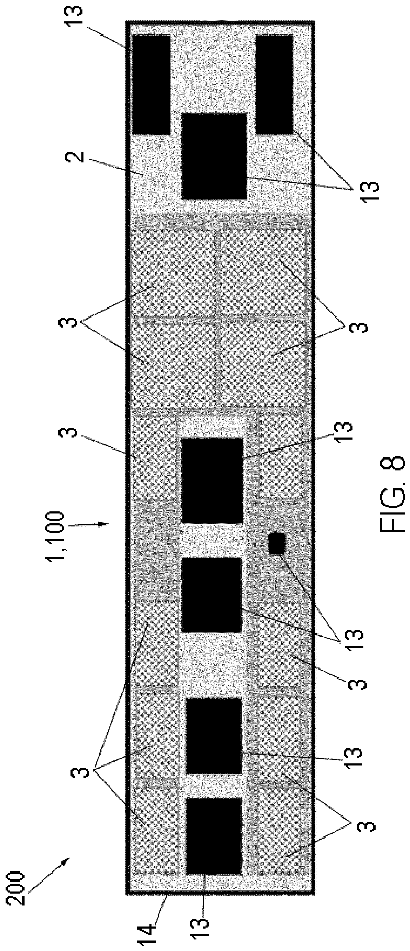

Fig. 8 is a top view of a further exemplary embodiment of a solar sheet arrangement 200 according to the invention comprising a pre-assembled solar sheet 1 identical to a solar sheet unit 100. In this embodiment, the solar sheet 1 is attached to a bus roof 14. Multiple solar modules 3 having two different sizes are attached to a carrier sheet 2 in different arrangements. Further, the carrier sheet 2 has multiple cut-outs 13 at various positions.

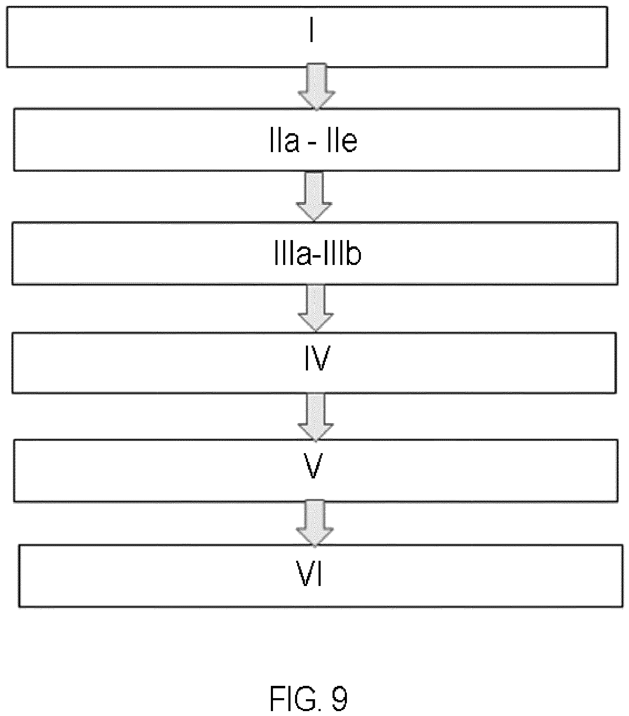

Fig. 9 is a flowchart illustrating an exemplary embodiment of a method for producing a solar sheet 1 (steps I through III) and an exemplary embodiment of a method for producing a solar sheet arrangement 200 (steps I through VI):
The method comprises the following steps:
I) providing a carrier sheet having a first side and a second side opposite to said first side,
II) producing at least one solar sheet unit, comprising:
   IIa) providing multiple electric conductors,
   IIb) arranging said electric conductors on and attaching to said first side and/or arranging said electric conductors on and attaching to said second side,
   IIc) providing multiple solar modules,
   IId) attaching said solar modules to said carrier sheet on said first side,
   IIe) electrically connecting said electric connectors of said solar modules to said electric conductors such that said solar modules are interconnected in series and/or in parallel,
      wherein one end portion of each one of said electric conductors lead to another solar module or into a common connection zone of the solar sheet unit,
IIIa) folding or winding the solar sheet into a folded or wound (rolled) configuration for transport, or
IIIb) cutting the solar sheet into solar sheet pieces, with each solar sheet piece comprising one or more solar sheet units, and stacking said solar sheet pieces,
IV) providing a support structure,
V) mounting of at least one solar sheet unit to the supporting structure,
VI) electrically connecting electric conductors from the common connection zone to an external power electronic unit such as MPP tracker/ MCU/ inverter.

The method of producing the solar sheet, i.e. the sequence within step II can be varied; another exemplary embodiment of step 2 comprises the following sub-steps:
IIa) providing multiple electric conductors and providing multiple solar modules,
IIb') electrically connecting said electric connectors of said solar modules to said electric conductors,
IIc') attaching a first solar to said carrier sheet on said first side,
IId') arranging said electric conductors on and attaching to said first side and/or arranging said electric conductors on and attaching to said second side, wherein one end portion of each one of said electric conductors lead to another solar module or into a common connection zone of the solar sheet unit,
IIe') repeating steps IIc') and IId') until all solar modules and all electrical connectors are attached such that said solar modules are interconnected in series and/or in parallel.

### LIST OF REFERENCE SIGNS

- 1: Solar sheet
- 2: Carrier sheet
- 3: Solar module
- 4: Electric conductor
- 5: End portion
- 6: Common connection zone
- 7,7',7",7‴: Segment
- 8,8',8": Folding line
- 9: Supporting structure
- 10,10': Adhesive
- 11,11': Intermediate space
- 12: Cylindrical drum
- 13: Cut-out
- 14: Bus roof
- 15: Electric connector

- 100: Solar sheet unit
- 200: Solar sheet arrangement

- A: First side
- B: Second side

## Claims

1. A solar sheet (1) for mounting on a supporting structure (9), comprising:
- a carrier sheet (2) having a first side (A) and a second side (B) opposite to said first side,
- at least one solar sheet unit (100), comprising:
i) multiple solar modules (3), attached to said carrier sheet (2) on said first side (A), each one of said solar modules (3) having electric connectors (15) for both electric polarities for providing electric power generated by said solar module (3),
ii) multiple electric conductors (4), attached to said first side (A) of said carrier sheet (2) and/or to said second side (B) of said carrier sheet (2), said electric connectors (15) of said solar modules (3) being electrically connected to said electric conductors (4) such that said solar modules (3) are interconnected in series and/or in parallel, with one end portion (5) of each one of said electric conductors (4) leading to either another solar module (3) or into a common connection zone (6) of said solar sheet unit (100).

2. The solar sheet (1) according to claim 1, wherein a plurality of said electrical conductors (4) end at said common connection zone (6) in such a manner that a plurality of said solar modules (3) can be connected in parallel to one external power electronic unit with one or several channels.

3. The solar sheet (1) according to claim 1 or 2, wherein said electric conductors (4) are configured as flat conductors.

4. The solar sheet (1) according to any one of the preceding claims 1 through 3, wherein said solar modules (3) are attached to said carrier sheet (2) in such a manner that a free intermediate space (11) is created between each one of said solar modules (3) and said carrier sheet (2), wherein said electric conductors (4) are attached to said first side (A) of said carrier sheet (2) in said free intermediate space (11).

5. The solar sheet (1) according to any one of the preceding claims 1 through 4, wherein said carrier sheet (2) has a bending stiffness such that the carrier sheet (2) is a flexible carrier sheet and/or said solar modules (3) have a bending stiffness such that said solar modules (3) are flexible solar modules.

6. The solar sheet (1) according to claim 5, wherein
i) said carrier sheet (2) is a flexible carrier sheet and said solar modules (3) are flexible solar modules, such that the solar sheet (1) can be bent into a rolled configuration, or
ii) said carrier sheet (2) is a flexible carrier sheet, such that the solar sheet (1) can be folded between adjacent solar modules (3).

7. The solar sheet (1) according to any one of the preceding claims 1 through 6, wherein said end portions (5) of said electric conductors (4) are connected to outlet sockets of a common connection box or a common multi-pin connector plug or are connected to single plugs.

8. The solar sheet (1) according to any one of the preceding claims 1 through 7, wherein said carrier sheet (2) has one or more marginal cut-outs (13) and/or one or more interior cut-outs (13).

9. The solar sheet (1) according to any one of the preceding claims 1 through 9, wherein said common connection zone (6) is located in an edge region of said solar sheet unit (100) or below one of said solar modules (3).

10. A solar sheet arrangement (200), comprising:
- a supporting structure (9), in particular a supporting layer which forms part of an outer skin of a vehicle or building,
- a solar sheet unit (100) of a pre-assembled solar sheet (1) according to any one of the preceding claims 1 through 10, mounted to said supporting structure (9),
wherein, in particular,
i) said solar modules (3) are attached to said carrier sheet (2) in such a manner that a free intermediate space (11) is created between each one of said solar modules (3) and said carrier sheet (2), wherein said electric conductors (4) are attached to said first side (A) of said carrier sheet (2) in said free intermediate space (11), and/or
ii) said carrier sheet (2) is attached to said supporting structure (9) in such a manner that a free intermediate space (1 1') is created between said second side (B) of said carrier sheet (2) and said supporting structure (9) and said electrical conductors (4) are attached on said second side (B) of said carrier sheet (2) in said intermediate space (11').

11. A method for producing a solar sheet (1) for mounting on a supporting structure (9) according to any one of claims 1 through 9, comprising the following steps:
- providing a carrier sheet (2) having a first side (A) and a second side (B) opposite to said first side,
- producing at least one solar sheet unit (100),
comprising:
i) providing multiple electric conductors (4),
ii) attaching said electric conductors (4) to said first side (A) and/or to said second side (B) of said carrier sheet (2),
iii) providing multiple solar modules (3),
iv) attaching said solar modules (3) to said carrier sheet (2) on said first side (A),
v) electrically connecting said electric connectors (15) of said solar modules (3) to said electric conductors (4) such that said solar modules (3) are interconnected in series and/or in parallel, wherein one end portion (5) of each one of said electric conductors (4) is led to another solar module (3) or into a common connection zone (6) of said solar sheet unit (100),
or comprising:
i') providing multiple electric conductors (4) and providing multiple solar modules (3),
ii') electrically connecting said electrical connectors (15) of said solar modules (3) to said electrical conductors (4),
iii') attaching a first one of said solar modules (3) to said carrier sheet (2) on said first side (A),
iv') arranging said electric conductors (4) of the solar module (3) on and attaching to said first side (A) and/or arranging said electric conductors (4) on and attaching to said second side (B), wherein one end portion of each one of said electric conductors (4) lead to another solar module (3) or into a common connection zone (6) of the solar sheet unit (100),
v') repeating steps iii') and iv') until all solar modules (3) and all electric conductors (4) are attached such that said solar modules (3) are interconnected in series and/or in parallel.

12. The method according to claim 11, further comprising one or more of the following steps:
- winding said solar sheet (1) into a rolled configuration, in particular spirally rolled configuration,
- winding said solar sheet (1) onto a cylindrical drum (12),
- single or multiple folding of said solar sheet (1) into a folded configuration having one or more folding lines (8, 8', 8") between adjacent solar modules (3),
- cutting said solar sheet (1) into two or more solar sheet pieces, with each solar sheet piece comprising one or more solar sheet units (100), and stacking said solar sheet pieces.

13. A method for producing a solar sheet arrangement (200) according to claim 10, comprising the following steps:
- providing a supporting structure (9), in particular a supporting layer which forms part of an outer skin of a vehicle or building,
- providing at least one solar sheet unit (100) of a pre-assembled solar sheet (1) according to any one of the preceding claims 1 through 9,
- mounting said solar sheet unit (100) to said supporting structure (9).

14. The method according to claim 13, wherein said solar sheet unit (100) is provided by unrolling said solar sheet unit (100) from a rolled configuration of said solar sheet unit (100) or solar sheet (1) or by unfolding said solar sheet unit (100) from a folded configuration of said solar sheet unit (100) or solar sheet (1).

15. The method according to claim 13 or 14, wherein
- said solar sheet unit (100) is mounted to said supporting structure (9) in such a manner that a free intermediate space (11') is created between said solar sheet unit (100) and said supporting structure (9) and said electric conductors (4) are attached to said second side (B) of said carrier sheet (2) in said free intermediate space (1 1'), and/or
- before mounting to said supporting structure (9), said solar sheet unit (100) is cut from a solar sheet (1).
